# EUROPEAN PATENT APPLICATION

(11) **EP 4 723 818 A1**
(43) Date of publication of application: **08.04.2026**
(21) Application number: 24204846.0
(22) Date of filing: 04.10.2024
(51) Int. Cl.: H05K 7/20, H01Q 1/32

(54) **ELECTRONIC TELECOMMUNICATION DEVICE HOSTING CIRCUIT BOARDS**

(71) Applicant: Valeo Comfort and Driving Assistance, 94000 Créteil (FR)
(72) Inventor: GUDDETI, Naveena, 94000 Créteil (FR); AKBARPOUR, Alireza, 94000 Créteil (FR); GLEICH, Hubert, 94000 Créteil (FR); GOEHRING, Tim, 94000 Créteil (FR)
(74) Representative: Delaval, Guillaume Laurent

(57) **Abstract**

The invention relates to an electronic telecommunication device comprising a casing enclosing a main electronic circuit board (4) and a daughter electronic circuit board (5), the daughter electronic circuit board being arranged at a distance from the main electronic circuit board so that a first face (7) of the daughter electronic circuit board is facing a first face (6) of the main electronic circuit board and carries an electronic module (9), the casing comprising a first casing portion (3) configured to be in contact with at least one point of a second face (18) of the main electronic circuit board opposite to the first face, wherein the casing comprises an extension (11) that extends from the first casing portion toward the second area of the daughter electronic circuit board so as to be in contact with the electronic module (9).

## Description

### TECHNICAL FIELD OF THE INVENTION

The invention pertains to the field of telecommunication, and specifically the field of telecommunication for automotive vehicles.

More precisely, the invention relates to an electronic telecommunication device.

### BACKGROUND INFORMATION AND PRIOR ART

Some automotive vehicles comprise telecommunication devices for communicating with other vehicles, receiving position related data or acceding to the internet. The number of telecommunication applications available for an automotive vehicle increasing with time, the number of antennas to place in a same device has become important. For instance, a same telecommunication device may host a Global Navigation Satellite System (GNSS), a Satellite Digital Audio Radio Service (SDARS), a wifi module, a Bluetooth module, etc.

Usually, the telecommunication devices comprise a casing enclosing an electronic circuit board. In order to reduce the heat elevation in the electronic telecommunication device, a wall of the casing may comprise a thermally conductive material and a face of the electronic circuit board may be placed in contact with the wall. Therefore, the heat generated by the component on the electronic circuit board is evacuated outward the device through the thermally conductive wall.

Given the high density of components on the electronic board, some devices include a daughter board that is separate from a main electronic board (or motherboard) and placed at a distance from it. This daughter board cannot therefore take advantage of the thermally conductive wall and the components it contains run the risk of overheating.

### SUMMARY OF THE INVENTION

The invention provides a solution to the above-mentioned technical problem, by providing an electronic communication device in which the overheating of the daughter board is avoided or limited.

According to an aspect of the invention, it is provided an electronic telecommunication device comprising a casing enclosing a main electronic circuit board and a daughter electronic circuit board, the daughter electronic circuit board being arranged at a distance from the main electronic circuit board so that a first face of the daughter electronic circuit board is facing a first face of the main electronic circuit board and carries an electronic module, the casing comprising a first casing (for instance, a base plate) portion configured to be in contact with at least one point of a second face of the main electronic circuit board opposite to the first face, wherein the first casing portion comprises an extension that extends toward the daughter electronic circuit board so as to be in contact with the electronic module.

According to an embodiment, the extension comprises a first portion extending orthogonally from the first casing portion, orthogonally to the first face of the main electronic circuit board, and a second portion extending orthogonally from the first portion and contacting the electronic module.

According to an embodiment, the second portion extends in a direction opposite to the main electronic circuit board.

According to an embodiment, the casing is made in a metallic material.

According to an embodiment, the casing is made in a material having a thermal conductivity higher than 20 W.m⁻¹.K⁻¹, and preferably higher than 60 W.m⁻¹.K⁻¹.

According to an embodiment, the daughter electronic circuit board is removably attached to the first casing portion.

According to an embodiment, the extension extends from an edge of the first casing portion.

According to an embodiment, the electronic module is a tuner.

According to an embodiment, the tuner is configured to tune and/or demodulate a signal received from a Satellite Digital Audio Radio Service antenna located on the daughter electronic circuit board.

According to an embodiment, a second face of the daughter electronic circuit board opposite to the first face comprises an antenna.

According to an embodiment, the electronic telecommunication unit is a telematic control unit intended to be located in the roof area of an automotive vehicle.

According to an embodiment, the first portion of the casing comprises a housing configured to receive the main electronic circuit board, the housing being divided into compartments by a wall extending from one edge of the housing to the other and on which the main electronic circuit board is configured to lie.

### DETAILED DESCRIPTION OF EXAMPLE(S)

The following description with reference to the accompanying drawings will make it clear what the invention consists of and how it can be achieved. The invention is not limited to the embodiment illustrated in the drawings. Accordingly, it should be understood that where features mentioned in the claims are followed by reference signs, such signs are included solely for the purpose of enhancing the intelligibility of the claims and are in no way limiting on the scope of the claims.

In the accompanying drawings:
- Figure 1 is a schematic view of an telecommunication system involving an automotive vehicle equipped with an electronic telecommunication device according to the invention;
- Figure 2 is a schematic side view of the electronic telecommunication device of figure 1;
- Figure 3 is a schematic top view of a lower portion of a casing of the electronic telecommunication device of figure 1.

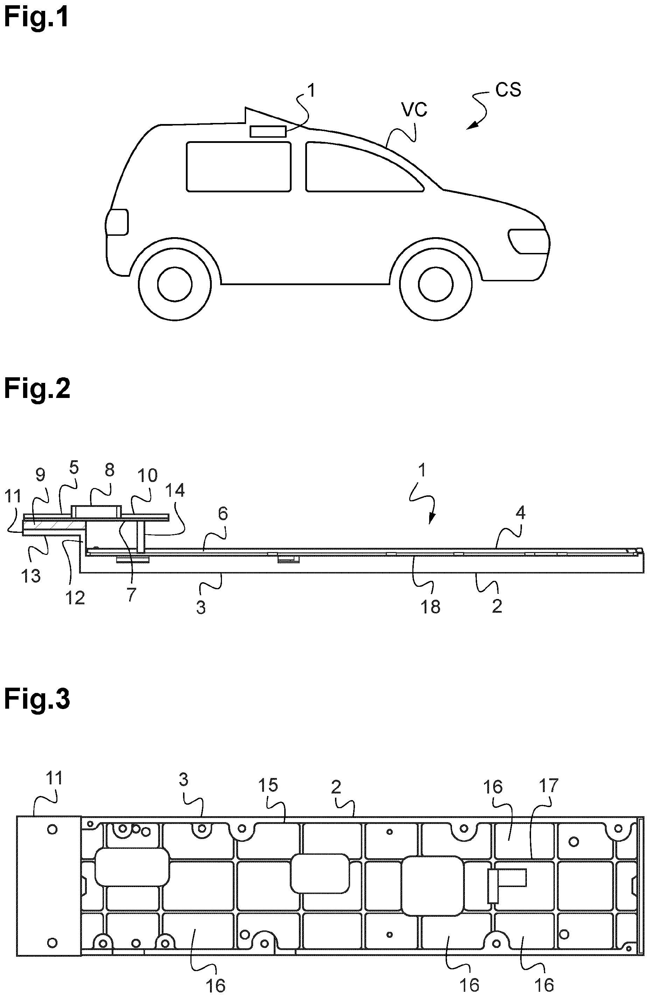

The telecommunication system CS as shown in figure 1 comprises an automotive vehicle VC, here a car, equipped with an electronic telecommunication device 1 according to an embodiment of the invention. The electronic telecommunication device 1 is here located on the roof of the automotive vehicle VC. The electronic telecommunication device 1 of this example is a Telematic Control Unit (TCU) configured to establish wireless communication links with distant networks or devices, for instance a navigation satellite from which the electronic telecommunication device 1 may receive positioning and navigation data, a cellular network, other automotive vehicles, etc.

The electronic telecommunication device 1 according to this embodiment is shown in figure 2. It comprises two electronic circuit boards 4, 5 enclosed in a casing, only a portion 2 of which is shown on figure 2. The electronic circuit boards 4, 5 comprised a main electronic circuit board 4 (or mother electronic circuit board) and a daughter electronic circuit board 5.

The main electronic circuit board 4 and the daughter electronic circuit board 5 have each a rectangular shape. Both can have a width lower or equal to 70 millimeters, for instance 69.40 millimeters. The thickness of the electronic telecommunication device 1 (the dimension measured in a direction orthogonal to the surface of the electronic circuit board) is lower or equal to 35 millimeters, for instance 34.63 millimeters.

The daughter electronic circuit board 5 is placed at a distance from the main electronic circuit board 4. For instance here, the main electronic circuit board 4 and the daughter electronic circuit board 5 are parallel to each other, and a first face 6 of the main electronic circuit board 4 is partially in vis-à-vis with a first face 7 of the daughter electronic circuit board 5. The electronic circuit boards 4, 5, are placed relatively to each other so as to share a same longitudinal symmetry plane.

In this configuration, the assembly including the two electronic circuit boards 4, 5 has a total length lower or equal to 320 millimeters, for instance 316 millimeters, and a width of lower or equal to 70 millimeters, for instance 69.40 millimeters.

The electronic circuit boards 4, 5 comprise a plurality of antennas and their corresponding electronic circuits, for instance cellular antennas (Low band, medium band and/or high band antennas), V2X (vehicle-to-everything) antennas, wifi antennas, Ultra Wide Band (UWB) antennas, Bluetooth antennas, global navigation satellite system (GNSS) antennas, and a SDARS (Satellite Digital Audio Radio Service) antenna 6.

Here, the daughter electronic circuit board 5 comprises the SDARS antenna 8 and an electronic module 9, in this example a tuner configured to process the signal received from the SDARS antenna 8. The electronic module 9 is located on an area of the first face 7 of the daughter electronic circuit board 5 which is not in vis-à-vis with the first face 6 of the main electronic circuit board 4, and the SDARS antenna 8 is located on a second face 10 of the daughter electronic circuit board 5 opposite to the first face 7. In other embodiments, the electronic module 9 is partially in vis-à-vis with the main electronic circuit board. The main electronic circuit board 4 comprises the other above-mentioned antennas (not shown) and in this example, there is no electrical connection between the mother electronic circuit board 4 and the daughter electronic circuit board 5. In this example, the SDARS antenna 8 is at the centre of the daughter electronic circuit board 5 to have even ground. The daughter electronic circuit board 5 can comprise more antennas. The height between the daughter electronic circuit board 5 and the main electronic circuit board 4 could be adapted depending on the size of the electronic module 9 of the daughter electronic circuit board 5. Preferably, the electronic module 9 on the daughter electronic circuit board 5 is not in vis-à-vis of the main electronic circuit board 4. In embodiments where the electronic module 9 is in vis-à-vis of the main electronic circuit board 4, additional cooling supporting means could be used.

The portion 2 of the casing is a lower portion 2. The term lower is, in this context, relative to the position of the electronic telecommunication device 1 in the vehicle VC. Here, the electronic telecommunication device 1 is located in the roof area of the automotive vehicle VC, and the lower portion is the portion of the casing which is the closest to the floor of the automotive vehicle 1.

The lower portion 2 comprises a substantially planar first casing portion, here a base plate 3, which is in contact with a second face 18 of the main electronic circuit board 4. Here, the main electronic circuit board 4 lies on the base plate 3. The lower portion 2 further comprises an extension 11 that extends toward the first face 7 of the daughter electronic circuit board 5 so as to be in contact with the electronic module 9. In other words, the lower housing bends in a way to come in contact with the electronic module 9. Here, the extension 11 comprises a first portion 12 which extends from one edge of the base plate 3, orthogonally to the base plate 3 (or, in this example, orthogonally to the faces 6, 7, 8 of the electronic circuit boards 4, 5) and towards the daughter electronic circuit board 5, and a second portion 13 which extends from an end of the first portion 12, here an end portion opposite to the base plate 3. The second portion 13 extends in a direction opposite to the base plate 3 (it does not extend above - or in vis à vis with - the base plate 3) and in a substantially parallel way to the first face 7 of the daughter electronic circuit board 5. The second portion 13 is in contact with at least one point of the electronic module 9, here with a whole surface of the electronic module 9.

Here, the daughter electronic circuit board 5 is held at distance from the main electronic circuit board 4 by the extension 11 and by a support pin 14 extending (for instance orthogonally) from the base plate 3 through the main electronic circuit board 4.

In the described embodiment, the lower portion of the casing (comprising the base plate 3 and the extension 11) is made in a material having a thermal conductivity higher than 20 W.m⁻¹.K⁻¹, and preferably higher than 60 W.m⁻¹.K⁻¹ . For instance, the casing comprises a metallic material, for instance aluminium and has a thermal conductivity of 230 W.m⁻¹.K⁻¹.

In this embodiment, the main electronic circuit boards 4, 5 are attached to the lower portion 2 of the casing. For instance, the main electronic circuit board 4 is clipped to the base plate 3, and the daughter electronic circuit board 5 is screwed to the lower portion. For instance, the daughter electronic circuit board is screwed to the support pin 14.

As shown in figure 3, the baseplate 3 of this embodiment comprised a housing 15 in which the main electronic circuit board 4 is placed. The housing is divided into a plurality of compartments 16 delimited by walls 17. The base plate 3, the compartments 16 and the walls 17 are made in a same material. For instance, the lower portion 2 has been made by molding. The compartments 16 are each adapted to house one or several electronic modules located on the second face 18 of the main electronic circuit board 4 and to act as electromagnetic shields for these electronic modules. To this end, lower portion 2 is electrically connected to a ground terminal.

The invention is not limited to the embodiments described above. For instance, it has been described an extension extending from an edge of the base plate and contacting an electronic module on a daughter electronic circuit board which is only partially in vis-à-vis with the main electronic circuit board. In other embodiments, the daughter electronic circuit board may be placed anywhere relatively to the main electronic circuit board (but still at distance), and the extension may extend accordingly from any location of the base plate. For instance, the extension may extend from the middle of the base plate (at distance from the edges), through an opening in the main electronic circuit board.

It has been described an electronic module being a tuner of a SDARS antenna. The invention is not limited to this example and the electronic module may be any electronic module associated to any kind of antenna or not associated to any antenna.

Furthermore, it has been described an electronic telecommunication device being a telematic control unit (TCU) installed in the roof area of a car. The electronic telecommunication device may be of any kind and installed in any kind of vehicle, for instance a plane or a boat, and located in any place of the vehicle.

## Claims

1. Electronic telecommunication device comprising a casing enclosing a main electronic circuit board (4) and a daughter electronic circuit board (5), the daughter electronic circuit board (5) being arranged at a distance from the main electronic circuit board (4) so that a first face (7) of the daughter electronic circuit board (5) is facing a first face (6) of the main electronic circuit board (4) and carries an electronic module (9), the casing comprising a first casing portion (3) configured to be in contact with at least one point of a second face (18) of the main electronic circuit board (4) opposite to the first face (6), wherein the casing comprises an extension (11) that extends from the first casing portion (3) toward the daughter electronic circuit board (5) so as to be in contact with the electronic module (9).

2. Electronic telecommunication device according to any one of claim 1, wherein the extension (11) comprises a first portion (12) extending orthogonally from the first casing portion (3), orthogonally to the first face (6) of the main electronic circuit board (4), and a second portion (13) extending orthogonally from the first portion (12) and contacting the electronic module (9).

3. Electronic telecommunication device according to any one of claim 2, wherein the second portion (13) extends in a direction opposite to the main electronic circuit board (4).

4. Electronic telecommunication device according to any one of claims 1 to 3, wherein the casing is made in a metallic material.

5. Electronic telecommunication device according to any one of claim 1 to 4, wherein the casing is made in a material having a thermal conductivity higher than 20 W.m⁻¹.K⁻¹.

6. Electronic telecommunication device according to any one of claim 1 to 5, wherein the daughter electronic circuit board (5) is removably attached to the first casing portion (3).

7. Electronic telecommunication device according to any one of claim 1 to 6, wherein the extension (11) extends from an edge of the first casing portion (3) of the casing.

8. Electronic telecommunication device according to any one of claims 1 to 7, wherein the electronic module (9) is a tuner.

9. Electronic telecommunication device according to claim 8, wherein the tuner (9) is configured to tune a signal received from a Satellite Digital Audio Radio Service antenna (8) located on the daughter electronic circuit board (5).

10. Electronic telecommunication device according to any one of claims 1 to 9, wherein a second face (10) of the daughter electronic circuit board opposite to the first face (7) comprises an antenna.

11. Electronic telecommunication device according to any one of claim 1 to 10, which is a telematic control unit intended to be located in the roof area of an automotive vehicle (VC).
